# EUROPEAN PATENT APPLICATION

(11) **EP 0 607 935 A2**
(43) Date of publication of application: **27.07.1994**
(21) Application number: 94100699.1
(22) Date of filing: 19.01.1994
(51) Int. Cl.: H01L 21/331, H01L 29/73, H01L 21/203

(54) **Heterojunction bipolar transistor fabrication method with low temperature base growth**

(30) Priority: 22.01.1993 US 7427
(71) Applicant: Hughes Aircraft Company, Los Angeles, California 90045-0066 (US)
(72) Inventor: Metzger, Robert A., Thousand Oaks, CA 91362 (US); Hafizi, Madjid, Santa Monica, CA 90405 (US); Stanchina, William E., Thousand Oaks, CA 91362 (US); McCray, Loren G., Jr., Thousand Oaks, CA 91360 (US)
(74) Representative: Witte, Alexander, Dr.-Ing.

(57) **Abstract**

Diffusion of p-type Be dopant out of the base (40) of an npn heterojunction bipolar transistor (HBT) during the transistor fabrication is prevented by growing the base (40) at a low temperature, generally within the range of about 280°-420°C for a AlInAs/GaInAs device. The DC current gain is maximized by growing the base (40) at the highest permissible temperature before outdiffusion occurs, which is substantially above the Be precipitation temperature.

## Description

### BACKGROUND OF THE INVENTION

### Field of the Invention

This invention relates to the fabrication of electrical devices with a confined highly p doped region, such as npn heterojunction bipolar transistors (HBTs) with a highly p doped base, in which diffusion of the p dopant out of its confined region is inhibited.

### Description of the Related Art

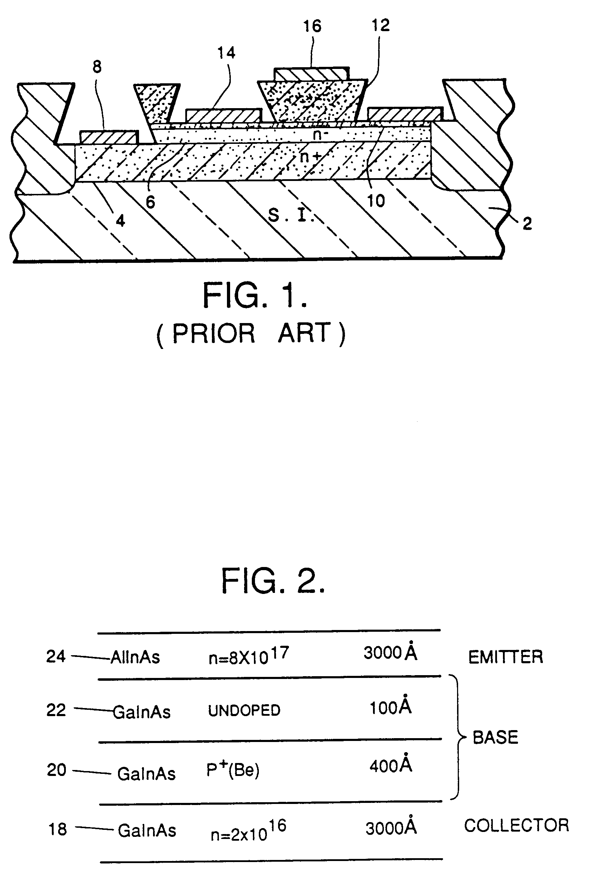

HBTs represent a field of increasing interest because of their potential for higher emitter efficiency, decreased base resistance, less emitter current crowding, improved frequency response and wider temperature range of operation. A representative HBT is illustrated in FIG. 1. It includes a semi-insulating semiconductor substrate 2, typically InP or GaAs. A highly doped n+ subcollector layer 4 on the substrate provides an underlying contact with the more lightly n- doped collector layer 6, with a metallized or highly doped semiconductor pad 8 providing a collector contact through the subcollector. A p+ base layer 10 is formed over the collector, with an n doped emitter 12 over the central portion of the base and a lateral base contact 14 surrounding the emitter. An emitter contact 16 is provided on the emitter's upper surface.

HBTs commonly use beryllium as the base dopant. Because of a diffusion problem encountered with Be, which the present invention seeks to alleviate, carbon has also been used as a base dopant to a certain extent. However, carbon is not as effective a dopant as Be, especially in In compounds.

It is generally desirable to establish a high level of base doping for an npn HBT. A high doping level reduces the base sheet resistance, which in turn increases the transistor's maximum frequency of operation fₘₐₓ. Unfortunately, Be tends to diffuse out of the base during the usual molecular beam epitaxy (MBE) growth process if the attempted dopant level is too high. As a practical matter, Be base doping levels have been limited to about 2×10¹⁹cm⁻³ because of the diffusion problem. An ability to increase this doping level will result in higher fₘₐₓ values, which in turn would improve the circuit's or system's speed of operation. Such enhanced HBTs could be used in both digital and analog systems, and would be particularly applicable to analog-to-digital converters (ADCs) in which the added speed could translate to either a faster converter, or to a larger bit capacity for a given operating speed.

One method that has been used to reduce the movement of Be from the base to the emitter of an npn AlInAs/GaInAs (emitter/base) HBT involved adding a spacer layer of GaInAs at the emitter/base junction. Stanchina et al., "Improved High Frequency Performance of AlInAs/GaInAs HBTs Through the Use of Low Temperature GaInAs", 2d Int'l. Conf. on Indium Phosphide and Related Materials, April 23-25, 1990, pages 13-16. The spacer layer was grown at a temperature of 300°C, which is about 200°C below the normal HBT growth temperature. This allowed the Be doping level in the base to be increased because Be diffusion, which increases at higher doping levels, was inhibited by the low temperature growth GaInAs spacer. The technique allows base doping levels to be increased by up to a factor of 2, increasing the hole concentration in the base from 1.5×10¹⁹cm⁻³ without the spacer to 3.0×10¹⁹cm⁻³ with the spacer. This modest increase in doping level was accompanied, however, by an increased transit time of electrons in the device.

Enhanced Be doping has also been achieved by low temperature growth of GaInAs thin films (500-4,000 Angstroms). Nottenburg et al., "InP-Based Heterostructure Bipolar Transistor", Proc. of the 1989 GaAs IC Symposium, 1989, pages 135-138; Hamm et al., "Ultrahigh Be doping of Ga_{0.47}In_{0.53}As by low temperature molecular beam epitaxy", Applied Physics Letters, Vol. 54, No. 25, 19 June 1989, pages 2586-2588. It was demonstrated that higher Be doping levels could be obtained at lower growth temperatures. At lower growth temperatures more vacancies are created, which allows more Be to be substitutionally incorporated into the lattice. At any given growth temperature there is a maximum Be doping level, due to the fact that at each growth temperature there are a finite number of vacancies created; the lower the growth temperature, the greater are the number of vacancies and therefore the higher is the maximum doping level. This information was used to grow InP/GaInAs HBTs in which the base region was grown at low temperature, thereby permitting a higher doping level. Maximum doping levels at a given temperature before Be precipitation occurred were established. However, this work did not address the issue of Be diffusion out of the base. Thus, the maximum doping levels that were claimed would suffer from extensive diffusion, and would not be applicable in the base of an HBT. Furthermore, very high doping levels result in a degradation in the crystalline quality, which is reflected in a reduction of the DC current gain β. The cited references also did not address the degradation of crystalline quality, and resulted in undesirable β reductions.

Be diffusion during subsequent annealing has also been reduced in GaAs by the use of higher As overpressures during Be growth. Miller et al., "Control of Be diffusion in molecular beam epitaxy GaAs", Applied Physics Letters, Vol. 46, No. 10, 15 May 1985, pages 960-962. The use of higher As overpressures during MBE growth results in more As at the sample's growing surface. This increased As impedes the movement of Ga into the desired lattice sites, which in turn generates Ga vacancies in the lattice. These vacancies capture Be ions, making them resistant to diffusion. Disadvantages of this approach are that it requires a higher As flux, and also that the range of vacancy creations that can be obtained by changing the As flux is quite limited because it is a linear process.

### SUMMARY OF THE INVENTION

The present invention seeks to provide a method of fabricating an HBT with substantially higher base doping levels, without either significant Be diffusion out of the base or a degradation of the DC current gain β.

These goals are achieved by selecting a desired dopant level for the base of an HBT, growing the base by MBE with a Be dopant at the selected concentration, and maintaining the base during its growth within a temperature range that is sufficiently low so that the Be dopant does not substantially diffuse out of the base, but above the temperature at which Be precipitation occurs. The temperature is preferably maintained at approximately a maximum temperature within this range, which optimizes the crystalline quality and thus maximizes the transistor gain. High levels of Be base doping, up to about 2×10²⁰cm⁻³, can be obtained. Depending upon the particular doping level desired, the base growth temperature will generally be within the range of 280°-420°C.

These and further features and advantages of the invention will be apparent to those skilled in the art from the following detailed description, taken together with the accompanying drawings.

### BRIEF DESCRIPTION OF THE DRAWINGS

FIG. 1 is a sectional view of a known HBT, described above;
FIG. 2 is a material diagram of an HBT that was used to demonstrate an increase in Be dopant diffusion out of the base as the base dopant level was increased;
FIG. 3 is a graph showing the results obtained with the FIG. 2 demonstration;
FIG. 4 is a material diagram of an HBT that was used to demonstrate the dependance of base dopant diffusion and maximum concentration upon growth temperature;
FIG. 5 is a graph of the results obtained with the FIG. 4 demonstration; and
FIG. 6 is a graph that relates the maximum base doping level before diffusion takes place to the growth temperature, for the HBT structure of FIG. 2.

### DETAILED DESCRIPTION OF THE INVENTION

The present invention offers two unique advantages: (1) an ability to keep high levels of Be (up to about 2×10²⁰cm⁻³) within the defined p base region of an HBT by low temperature MBE growth; and (2) the establishment of optimum growth temperatures for desired base doping levels that both inhibits Be diffusion, and optimizes the crystalline quality to maximize transistor gain. Although it is described herein in terms of an HBT with an AlInAs emitter and a GaInAs base, it is applicable to other emitter/base combinations that can be used for an npn HBT with Be base doping, such as AlGaAs/GaAs, GaAs/GaInP and InP/GaInAs (the base and emitter materials can also be switched), and more generally to other electrical devices in which a high level of confined Be doping is desired.

The technique involves holding the HBT substrate at a low temperature during MBE growth of the base. When a GaInAs base is grown at low temperature, the residence time of an As atom which strikes the surface (the time it resides on the surface before being desorbed) is greatly increased because of the lower thermal energy it receives from the substrate. This increased dwell time effectively increases the amount of As on the surface at any given time, which in turn impedes Ga, In and Al surface diffusion, thereby creating vacancies into which Be ions can lock. The effect is similar to an increase in the As flux, but does not require any increase in As flux. Furthermore, since the surface residence time is exponential in nature with respect to the growth temperature, rather than the linear relationship between As flux and vacancy creation, it allows for a much greater range in the creation of lattice vacancies.

The present inventors have observed that, when Be doping is performed during MBE, a desired abrupt Be profile can be achieved only for some maximum doping level. If higher doping levels are attempted by increasing the Be flux, the additional Be rapidly diffuses out of the intended area. FIG. 2 shows an HBT structure with which this effect was demonstrated. It included a 3,000 Angstrom GaInAs collector layer 18 that was n doped with silicon to a concentration of 2×10¹⁶cm⁻³, a 400 Angstrom GaInAs p+ base layer 20 that was doped with Be, a 100 Angstrom GaInAs undoped base spacer layer 22 and a 3,000 Angstrom AlInAs emitter layer 24 with an n dopant concentration of 8×10¹⁷cm⁻³; electrical contacts were also formed, but are not shown.

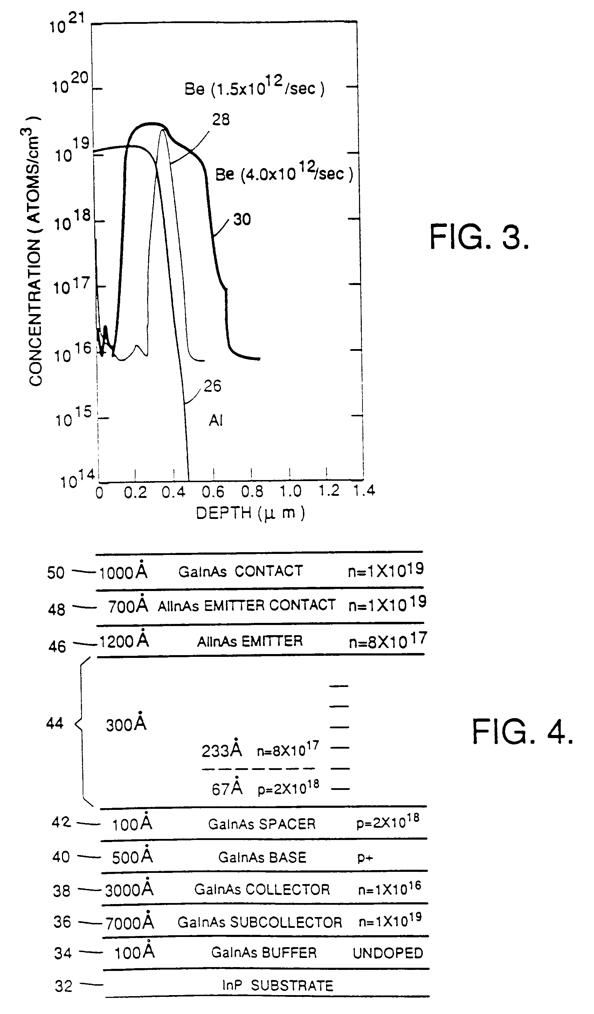

The structure of FIG. 3 was grown at a temperature of 450°C. In one case the Be flux was 1.5×10¹²/sec, and in a second case it was 4.0×10¹²/sec. A secondary ion mass spectrograph of the Be distribution resulting from the two different fluxes and for the emitter Al is shown in FIG. 3 as a function of depth into the device. The Al profile 26 defines the edge of the emitter. The Be profile 28 for the lower Be flux was generally confined to the base region, whereas the Be profile 30 for the higher Be flux diffused some 1,500 Angstroms into the emitter region.

The explanation for the observed dependence of Be diffusion upon its concentration is believed to be that Be incorporates into the vacancies created during crystal growth when Ga, In or Al are not incorporated into their preferred lattice sites. Be is a mobile, positive ion which diffuses interstitially in the lattice, only stopping when it encounters a vacancy where it is substitutionally trapped (Miller et al., supra). This implies that, for the higher dopant flux condition, there were not enough vacancies created in the base region to accommodate the increased number of Be atoms, and they therefore diffused into regions beyond the base where they were then substitutionally accommodated. Thus, if more vacancies can be generated within the base, it should be possible to obtain higher dopant levels before Be diffusion beyond the intended base region occurs.

Since vacancies are created when Ga, In and Al cannot surface diffuse on the growing MBE surface to their desired lattice sites, additional vacancies can be created and higher doping levels accordingly achieved if this movement can be impeded even more than that which occurs during typical MBE growth conditions. The low temperature growth employed by the invention is believed to increase the number of vacancies by two effects: (1) the thermal energy imparted to the Ga, In and Al atoms from the substrate is reduced, preventing these atoms from moving as rapidly or as far, and thereby inhibiting them from locating substitutional lattice sites and thereby creating vacancies; and (2) the As resides on the surface for a longer period of time for a low temperature substrate, thereby effectively increasing the As density on the surface so as to impede the surface diffusion of Ga, In and Al, and thus creating additional vacancies.

This hypothesis was tested by growing identical HBT structures, shown in FIG. 4, with the same Be flux used for growing the base. The only difference between the devices was the temperature at which the base was grown. In the first device the base growth temperature was 360°C, and in the second it was 280°C. The intended Be base doping level was 2×10²⁰cm⁻³ which was about 10 times higher than the doping level that can be achieved with MBE growth under typical growth temperatures of 500°C.

The test devices were formed by MBE on an InP substrate 32, with a 100 Angstrom GaInAs undoped buffer layer 34 over the substrate and then in succession a 7,000 Angstrom GaInAs subcollector layer 36 with an n doping of 1×10¹⁹cm⁻³, a 3,000 Angstrom GaInAs collector layer 38 with an n doping concentration of 1×10¹⁶cm⁻³, and a 500 Angstrom GaInAs base layer 40. A lightly doped 100 Angstrom spacer layer 42 was grown over the base to assist in precisely locating the device's p-n electrical junction in accordance with the teachings of copending application Serial No. by Metzger et al., "Electrical Junction Device With Lightly Doped Buffer Region to Precisely Locate a P-N Junction", filed on the same day as the present application and also assigned to Hughes Aircraft Company. A 300 Angstrom graded superlattice 44 was then grown over the spacer layer, consisting of 9 periods with each period having a layer of base/spacer material and another layer of emitter material. The superlattice was graded so that the layers of base/spacer material progressively dropped in width, and the layers of emitter material progressively increased in width, in discrete steps, for each successive period from the spacer to the emitter. Specifically, the superlattice periods were each 33.3 Angstroms wide, with the base/spacer layer dropping in 3.3 Angstrom steps from 30.0 Angstroms adjacent to the base to 3.3 Angstroms adjacent to the emitter. An electrical junction was established within the superlattice by doping the first two periods p-type at the spacer concentration of 2×10¹⁸cm⁻³, and the remaining 7 periods n-type at the emitter concentration of 8×10¹⁷cm⁻³. The superlattice is useful in preventing field-induced Be diffusion during the operation of the device (as opposed to the growth diffusion addressed by the present invention), and is taught in copending application Serial No. by the present inventors, "Gain-Stable NPN Heterojunction Bipolar Transistor", filed on the same day as the present application and also assigned to Hughes Aircraft Company. While the use of a spacer layer and superlattice is preferred, they are not necessary to the present invention. To complete the test HBT structure, a 1,200 Angstrom AlInAs emitter 46 was grown over the superlattice with an n-type silicon doping of 8×10¹⁷cm⁻³. Finally, a 700 Angstrom AlInAs emitter contact layer 48 with an n doping of 1×10¹⁹ cm⁻³ was grown over the emitter, followed by a 1,000 Angstrom GaInAs contact layer 50, also with an n-doping of 1×10¹⁹cm⁻³.

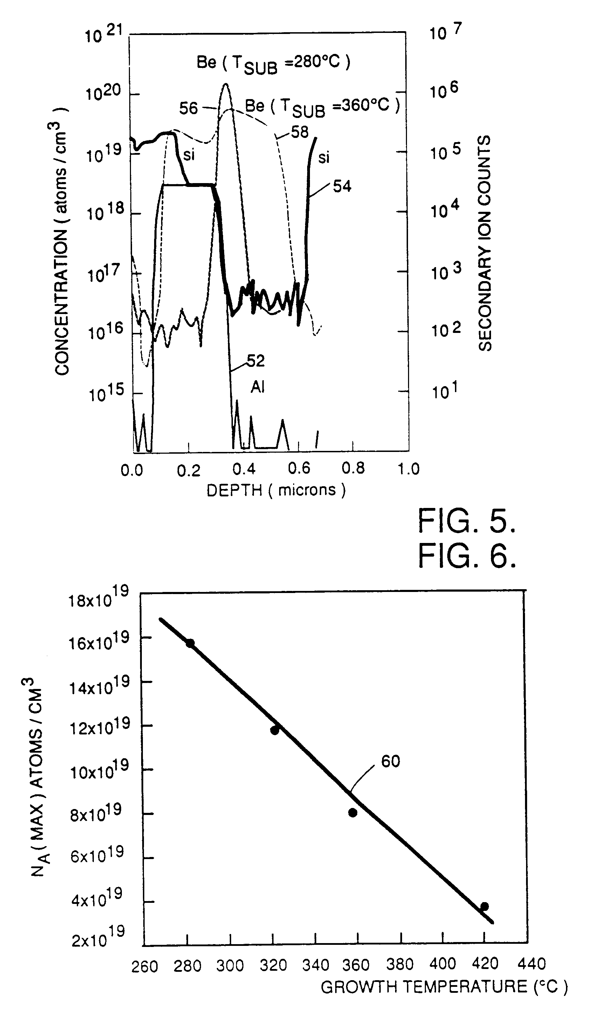

The results of growing the bases of the FIG. 4 HBTs at 360°C and 280°C are shown in FIG. 5. In this set of curves, the Al concentration 52 indicates the emitter and emitter contact layers 46 and 48, while the Si concentration 54 indicates the n doping used for the emitter, emitter contacts, collector and subcollector. As can be seen, the lower temperature growth curve 56 for the 280°C base growth resulted in a Be profile in the base that exhibited no diffusion, while the growth that was performed at 360°C (curve 58) resulted in severe diffusion out of the base. Furthermore, the growth at 360°C exhibited a maximum doping level approximately 5 times less than that with base growth at 280°C. This reflected the lower number of vacancies created with growth at 360°C, which did not permit as high a doping level. These results indicated that low temperature growth could be used to obtain higher doping levels, and that the growth temperature could be selected to avoid dopant diffusion out of the base.

For a particular desired doping level, there is a maximum base growth temperature that may be used before diffusion occurs. Although diffusion can be avoided simply by growing the base at a sufficiently low temperature to be sure that no diffusion will occur, keeping the base growth temperature lower than is absolutely required will result in an unnecessary degradation in the transistor's gain. Applicants have hypothesized that the same mechanism which produces the vacancies that capture the interstitial Be also creates other defects, such as Ga, In and Al antisite defects (sitting on the As lattice sites) and interstitial defects. These defects can act as recombination centers at which electrons that are injected from the emitter into the base will be recombined, and thereby degrade the transistor's gain.

Thus, for a desired doping level there is a critical growth temperature at which there will be substantially no Be diffusion, and at which the defects which cause recombination will be minimized. This optimum temperature is the one that is just sufficiently low enough to contain the Be within the base. Any lower temperature will also contain the Be, but at the same time will reduce the transistor gain. In accordance with the invention, the maximum base growth temperature is determined for a given doping level (or conversely the maximum doping level is determined for a given growth temperature), and this temperature and doping level are used to both prevent diffusion and to maximize the gain. The optimum temperature is considerably higher than the growth temperature previously used to maximize the Be doping level, as for example in the Hamm et al. article referenced above, without regard to Be diffusion.

A series of HBTs of the type shown in FIG. 2 were grown, with the substrate heated to a temperature within a range of 280°-420°C during the base growth, and intended base Be doping levels that ranged from 4×10¹⁹cm⁻³ to 1.6×10²⁰cm⁻³. Secondary ion mass spectroscopy was then used to inspect the Be profile, and thereby determine the conditions under which diffusion into the emitter took place. In this manner the maximum base doping level that could be achieved before diffusion occurred for a given substrate temperature was determined, as was the maximum substrate temperature that could be sustained for a given base doping level without diffusion. The results are shown in FIG. 6, which plots the maximum base doping level N_{A}(max) against the growth temperature. This technique of low temperature growth and establishment of the N_{A}(max) can be extended to other desired material systems.

Using FIG. 6, the maximum allowable doping level in the base of an npn AlInAs/GaInAs HBT can be determined. The test points are connected by a line 60. Attempting to dope at levels above this line results in Be diffusion from the base into the emitter. Growing the base in the region below the line (at a temperature lower than the temperature at which the Be is just being contained) will result in degraded gain. Thus, the optimum base growth temperature for any desired dopant level is right on the line, and represents an optimum balance between diffusion avoidance and high gain.

To demonstrate the effect of base growth temperature below the optimum line 60 upon transistor gain, three HBTs with a doping level of 6×10¹⁹cm⁻³ were grown with base growth temperatures of 360°, 320° and 280°C, respectively. All of these temperatures were below the optimum temperature for a N_{A}(max) of 6×10¹⁹cm⁻³, which according to FIG. 6 is 390°C for maximum gain. The results were consistent with the invention's hypothesis, and demonstrated that transistor gain progressively fell as the base growth temperature was reduced below the optimum level. Specifically, β's of 23, 11 and 8 were measured for the devices with bases grown at 360°, 320° and 280°C, respectively.

It has thus been demonstrated that base Be doping levels up to 1.6×10²⁰cm⁻³ can be achieved in an HBT without diffusion by low temperature growth of the base, and further that an optimum growth temperature can be established for a desired Be doping level at which no diffusion takes place and the DC current gain β is maximized. While several illustrative embodiments of the invention have been shown and described, numerous variations and alternative embodiments will occur to those skilled in the art. Such variations and alternate embodiments are contemplated, and can be made without departing from the spirit and scope of the invention as defined in the appended claims.

## Claims

1. A method of forming the base of an npn heterojunction bipolar transistor (HBT), comprising the steps of:
- selecting a p dopant concentration for the base (20, 22; 40); and
- growing the base (20, 22; 40) by molecular beam epitaxy (MBE) with a Be dopant at said selected concentration;
characterized by:
- maintaining the base (20, 22; 40) during its growth within a temperature range that is sufficiently low so that the Be dopant does not substantially diffuse out of the base (20, 22; 40) as a result of its growth, but substantially above the temperature at which said Be precipitates from the base (20, 22; 40).

2. The method of claim 1, characterized in that said base (20, 22; 40) is maintained during its growth at approximately a maximum temperature that does not result in substantial Be diffusion out of the base.

3. A method of growing the base of an npn heterojunction bipolar transistor (HBT), characterized by the steps of:
- determining the maximum temperature at which the base (20, 22; 40) can be grown with a Be dopant by molecular beam epitaxy (MBE) at a desired dopant concentration without substantial Be diffusion out of the base (20, 22; 40); and
- growing the base (20, 22; 40) with a Be dopant at approximately said desired concentration and at approximately said maximum temperature.

4. A method of forming an npn heterojunction bipolar transistor (HBT), comprising the steps of:
- growing in succession a collector (18; 38), base (20, 22; 40) and emitter (24; 46) upon a substrate (32) by molecular beam epitaxy (MBE); and
- doping said collector (18; 38) with an n dopant, said base (20, 22; 40) with Be and said emitter (24; 46) with an n dopant during their respective growths;
characterized by:
- maintaining the base (20, 22; 40) during its growth within a temperature range that is sufficiently low so that the Be dopant does not substantially diffuse out of the base (20, 22; 40) as a result of its growth, but substantially above the temperature at which said Be precipitates from the base (20, 22; 40).

5. The method of claim 4, characterized in that said base (20, 22; 40) is maintained during its growth at approximately a maximum temperature that does not result in substantial Be diffusion out of the base (20, 22; 40).

6. The method of claim 4 or 5, characterized in that said emitter (24; 46) is grown as GaInAs, GaAs, GaInP, InP, AlInAs or AlGaAs.

7. The method of any of claims 1 - 6, characterized in that said base (20, 22; 40) is grown at a temperature in the range of about 280°-420°C.

8. The method of any of claims 1 - 7, characterized in that said base (20, 22; 40) is grown as GaInAs, GaAs, GaInP, InP, AlInAs or AlGaAs.

9. A method of forming an electrical device with a confined p doped region, comprising the step of:
- growing a p doped semiconductor region by molecular beam epitaxy (MBE) with a Be dopant at a desired dopant concentration;
characterized by:
- maintaining said region during its growth within a temperature range that is sufficiently low so that the Be does not substantially diffuse out of said region as a result of its growth, but substantially above the temperature at which said Be precipitates from said region; and
- providing the remaining structure of said device, with at least a portion of said structure comprising a semiconductor material that has a lower doping level than said p doped region and is located adjacent to said region.

10. The method of claim 9, characterized in that said p doped region is grown at approximately a maximum temperature that does not result in substantial dopant diffusion out of said region.
